# EUROPÄISCHE PATENTSCHRIFT

(11) **EP 3 317 969 B1**
(45) Veröffentlichungstag und Bekanntmachung des Hinweises auf die Patenterteilung: **19.06.2019**
(21) Anmeldenummer: 16717836.7
(22) Anmeldetag: 15.04.2016
(51) Int. Cl.: H03K 17/965, G06F 3/01

(54) **KRAFTFAHRZEUG-BEDIENVORRICHTUNG MIT ZENTRIERTEM BETÄTIGUNGSELEMENT**
MOTOR VEHICLE OPERATING DEVICE HAVING A CENTRED ACTUATING ELEMENT
DISPOSITIF DE COMMANDE D'UN VÉHICULE AUTOMOBILE COMPRENANT UN ÉLÉMENT D'ACTIONNEMENT CENTRALISÉ

(30) Priorität: 02.07.2015 DE 102015008573
(43) Veröffentlichungstag der Anmeldung: 09.05.2018
(73) Patentinhaber: Audi AG, 85045 Ingolstadt (DE)
(72) Erfinder: WACHINGER, Michael, 86571 Winkelhausen (DE)
(86) Internationale Anmeldenummer: PCT/EP2016/000618
(87) Internationale Veröffentlichungsnummer: WO 2017/001032

(56) Entgegenhaltungen:
- EP-A1- 2 372 915
- EP-A1- 2 651 685
- DE-A1-102010 026 910
- US-A1- 2009 296 341
- US-A1- 2010 079 264
- US-A1- 2011 074 559
- US-A1- 2013 194 210

## Beschreibung

Die Erfindung betrifft eine Bedienvorrichtung für ein Kraftfahrzeug mit einem Betätigungselement, das bezüglich eines Gehäuses der Bedienvorrichtung bewegbar gelagert ist und eine Berühroberfläche für einen Benutzer aufweist. Das Betätigungselement kann beispielsweise als Taste oder Tastenleiste ausgestaltet sein. Um an der Bedienoberfläche eine haptische Rückmeldung oder ein haptisches Feedback zu erzeugen, ist eine Aktoreinrichtung zum Erzeugen einer Feedback-Bewegung des Betätigungselements bereitgestellt. Zu der Erfindung gehört auch ein Kraftfahrzeug mit der erfindungsgemäßen Bedienvorrichtung.

Ein Betätigungselement, dessen Bedienoberfläche von einer Aktoreinrichtung angeregt werden kann, muss hierzu derart beweglich in dem Gehäuse der Bedienvorrichtung angeordnet sein, dass die Feedback-Bewegung von dem Betätigungselement ausgeführt werden kann, ohne dass es hierbei an das Gehäuse anschlägt. In der Regel ist hierzu ein umlaufender Spalt um das Betätigungselement herum vorgesehen. Dieser muss dann von einer Blende oder Schindelung abgedeckt sein. Ursache dafür ist, dass der Spaltverlauf oder das Spaltmaß ungleichmäßig werden kann, da die Bedienoberfläche freischwingend ausgeführt sein muss und sich beispielsweise durch Antippen verlagern kann. Durch die notwendige Blende liegt die Bedienoberfläche aber stets in einer Mulde, so dass sich auch Staub und/oder Schmutzteile leicht auf der Bedienoberfläche sammeln können.

Bei einer Bedienvorrichtung mit einem Betätigungselement, das durch eine Aktoreinrichtung zu einer Feedback-Bewegung angeregt werden kann, ist somit das Einstellen eines Spaltmaßes eines Spalts oder einer Fuge zwischen dem Betätigungselement und dem Gehäuse der Bedienvorrichtung aufgrund der geforderten Beweglichkeit des Betätigungselements schwierig.

Aus der US 2006/0266633 A1 ist ein Kippschalter für ein Kraftfahrzeug bekannt, der sowohl im unbetätigten als auch im betätigten Zustand nicht über eine den Schalter umgebende plane Blendenfläche hinausragt. Hierzu ist eine Drehachse, um welche der Schalter beim Betätigen dreht, in einen Bereich neben dem Schalter verlagert.

Aus der US 2007/0227870 A1 ist ein Lampenschalter bekannt, der einen Knauf aufweist, der zum Schalten der Lampe nicht unbedingt zentral gedrückt muss, sondern auch an einer Kante mit einer Bedienkraft beaufschlagt und hierdurch lediglich gekippt werden braucht. Auch durch das Kippen kann hierbei die Lampe geschaltet werden. Der Knauf wird durch eine Spiralfeder in einer Ruhelage gehalten, wenn er nicht betätigt ist.

Aus der DE 1930465 U ist ein elektrischer Taster bekannt, der ein Betätigungselement aufweist, das durch eine Spiralfeder in eine Ruhelage gedrückt und hier durch eine Schraube gehalten wird, die ein Anschlagselement darstellt, welches einen Federweg der Spiralfeder begrenzt.

Aus der US 2013/0194210 A1 ist ein Berührungssensor mit einer Feedback-Bewegung bekannt.

Der Erfindung liegt die Aufgabe zugrunde, bei einer Bedienvorrichtung eines Kraftfahrzeugs trotz für eine Feedback-Bewegung vorgesehener Beweglichkeit des Betätigungselements dennoch eine definierte Ruhelage einzustellen.

Die Aufgabe wird durch die Gegenstände der unabhängigen Patentansprüche gelöst. Vorteilhafte Weiterbildungen der Erfindung sind durch die Merkmale der abhängigen Patentansprüche gegeben.

Durch die Erfindung ist eine Bedienvorrichtung für ein Kraftfahrzeug bereitgestellt. Die Bedienvorrichtung weist ein Betätigungselement auf, das bezüglich eines Gehäuses der Bedienvorrichtung bewegbar gelagert ist und eine Berühroberfläche für eine Bedienung durch einen Benutzer aufweist. Das Betätigungselement kann beispielsweise als Taste oder Tastenleiste oder Touchpad (berührsensitive Bedienfläche) ausgestaltet sein. Eine Sensoreinrichtung ist dazu ausgelegt, ein Sensorsignal in Abhängigkeit von einer benutzerseitigen Berührung der Berühroberfläche und/oder einer benutzerseitigen Annäherung an die Berühroberfläche zu erzeugen. Eine Steuereinrichtung ist derart eingerichtet, dass sie in Abhängigkeit von dem Sensorsignal ein Steuersignal für zumindest ein Gerät des Kraftfahrzeugs sowie mit dem Steuersignal auch ein Anregungssignal für eine Aktoreinrichtung erzeugt. Die Steuereinrichtung kann hierzu beispielsweise einen Mirkocontroller oder einen Mikroprozessor aufweisen.

Die Aktoreinrichtung ist zum Erzeugen einer Feedback-Bewegung des Betätigungselements in Abhängigkeit von dem Anregungssignal ausgelegt. Mit anderen Worten kann ein Benutzer das Betätigungselement berühren, was durch die Sensoreinrichtung mittels des Sensorsignals signalisiert wird. Die Sensoreinrichtung kann hierzu beispielsweise einen kapazitiven Näherungssensor oder eine Anordnung aus mehreren kapazitiven Näherungssensoren aufweisen. Die Steuereinrichtung erkennt anhand des Sensorsignals die Berührung und erzeugt das Steuersignal für das zumindest eine Gerät. Beispielsweise kann als Gerät jeweils ein Infotainmentsystem (Informations-Unterhaltungssystem), eine Klimaanlage, eine Telefonanlage oder eine Fahrwerkssteuerung vorgesehen sein. Um dem Benutzer zu signalisieren, dass ein Steuersignal ausgesendet wurde, erzeugt die Steuereinrichtung zudem das Anregungssignal. In Abhängigkeit von dem Anregungssignal bewirkt oder erzeugt die Aktoreinrichtung eine Feedback-Bewegung des Betätigungselements. Beispielsweise kann als Feedback-Bewegung eine Vibration des Betätigungselements oder ein einmaliges Auslenken des Betätigungselements vorgesehen sein, wobei das einmalige Auslenken dann vom Benutzer als Stoß oder Klicken empfunden wird. Das Auslenken dauert insbesondere weniger als 1 Sekunde, bevorzugt weniger als 500 Millisekunden.

Um nun das Betätigungselement in einer vorgegebenen Ruhelage zu halten, während es nicht bedient wird, ist das Betätigungselement im unbetätigten Zustand in einer Ruhelage angeordnet, in welcher zumindest ein Zentrierelement die Feedback-Bewegung blockiert. Mit anderen Worten ist das Betätigungselement im unbetätigten Zustand, wenn es nicht vom Benutzer durch eine Berührkraft beaufschlagt und/oder ausgelenkt ist, durch das zumindest eine Zentrierelement eingeklemmt oder festgehalten, so dass es die Feedback-Bewegung nicht ausführen kann. Durch Wahl der Form jedes Zentrierelements kann somit das Betätigungselement in eine vorbestimmte Ruhelage gebracht sein oder dort gehalten sein, so dass entsprechend auch z.B. ein Spaltmaß eine Spalts oder einer Fuge festgelegt ist, welche zwischen dem Betätigungselement und dem Gehäuse vorgesehen ist.

Um nun dennoch die Feedback-Bewegung zu ermöglichen, wechselt das Betätigungselement bei einer benutzerseitigen Beaufschlagung der Berühroberfläche mit einer Bedienkraft seine Lage. Das Betätigungselement führt aufgrund der Bedienkraft eine schräg oder senkrecht zur Richtung der Feedback-Bewegung ausgerichtete Ausweichbewegung aus, durch welche das Betätigungselement von der Ruhelage in eine Freilage wechselt, in welcher es durch das zumindest eine Zentrierelement für die Feedback-Bewegung freigegeben ist. Mit anderen Worten kann die Aktoreinrichtung das Betätigungselement nur in die Feedback-Bewegung versetzen, falls das Betätigungselement aus der Ruhelage durch die Ausweichbewegung in die Freilage gewechselt hat. Das Zentrierelement kann beispielsweise als Rahmen oder Ring ausgestaltet sein, welcher das Betätigungselement in der Ruhelage umgibt. Indem sich das Betätigungselement aus diesem Rahmen herausbewegt, kann es dann die Feedback-Bewegung ausführen.

Durch die Erfindung ergibt sich der Vorteil, dass im unbetätigten Zustand das Betätigungselement durch das zumindest eine Zentrierelement in der Ruhelage gehalten oder fixiert ist und hierdurch ein vorbestimmbares Spaltmaß oder eine vorbestimmte Lage des Betätigungselements in der Bedienvorrichtung eingestellt werden kann. Erst bei Betätigen des Betätigungselements, wenn ein Benutzer das Betätigungselement mit einer Bedienkraft beaufschlagt und es hierdurch aus der Ruhelage heraus bewegt oder auslenkt, wird das Betätigungselement derart beweglich, dass es die Feedback-Bewegung ausführt, wenn es durch die Aktoreinrichtung bewegt wird. Das zumindest eine Zentrierelement kann an dem Gehäuse oder an dem Betätigungselement befestigt sein.

Zu der Erfindung gehören auch optionale Weiterbildungen, durch deren Merkmale sich zusätzliche Vorteile ergeben.

Im Zusammenhang mit der Ausbildung eines Spalts oder einer Fuge mit vorgebbarem Spaltmaß oder Fugenmaß ist zwischen dem Betätigungselement und dem Gehäuse ein das Betätigungselement umgebender oder umschließender Spalt oder eine entsprechende Fuge vorgesehen. Des Weiteren ist bevorzugt vorgesehen, dass die Bedienoberfläche bündig und/oder plan mit einer Gehäusekante des Gehäuses abschließt. Mit anderen Worten ist vermieden, dass sich die Bedienoberfläche in einer Mulde befindet, die durch eine umlaufende Blende oder Schindelung gebildet ist.

Gemäß einer Weiterbildung ist vorgesehen, dass eine elastisch verformbar ausgestaltete Rückstelleinrichtung das Betätigungselement mit einer Rückstellkraft zur Ruhelage hin drückt oder zieht. Die Rückstelleinrichtung kann hierzu beispielsweise eine Feder aufweisen, die beispielsweise als Spiralfeder oder Blattfeder oder Tellerfeder ausgestaltet sein kann. Die Rückstelleinrichtung kann beispielsweise auf der Grundlage eines Kunststoffes oder eines Metalls gebildet sein. Insbesondere sind die Rückstelleinrichtung und das zumindest eine Zentrierelement verschieden. Durch die Weiterbildung ergibt sich der Vorteil, dass mittels der Rückstellkraft das Betätigungselement wieder in die Ruhelage gedrückt oder gezogen wird und hierbei die Rückstellkraft derart groß gewählt werden kann, dass das Betätigungselement und das zumindest eine Zentrierelement zusammen gepresst oder eingeklemmt werden. Hierdurch ergibt sich ein besonders fester Sitz des Betätigungselements in der Ruhelage.

Gemäß einer Weiterbildung ist das zumindest eine Zentrierelement in der Ruhelage des Betätigungselements zwischen dem Betätigungselement und einer das Betätigungselement umschließenden Blende des Gehäuses angeordnet. Mit anderen Worten wird das Betätigungselement durch das zumindest eine Zentrierelement direkt fixiert. Hierdurch ist die Toleranzkette beim Fertigen der Bedienvorrichtung in Bezug auf das Einstellen der Ruhelage minimiert. Das zumindest eine Zentrierelement fixiert das Betätigungselement nämlich direkt.

Gemäß einer Weiterbildung ist zwischen dem Betätigungselement und dem Gehäuse eine Fuge oder Spalt ausgebildet und das zumindest eine Zentrierelement ist in einem Abstand größer als Null zur Berühroberfläche in der Fuge oder in dem Spalt angeordnet oder versenkt. Mit anderen Worten ist das zumindest eine Zentrierelement von außen nicht sichtbar, weil es in der Fuge oder dem Spalt versenkt ist. Der Abstand beträgt bevorzugt mehr als 2 Millimeter, insbesondere mehr als 3 Millimeter.

Alternativ zu einem Zentrierelement, das in der Ruhelage direkt an dem Betätigungselement angeordnet ist, ist gemäß einer Weiterbildung vorgesehen, dass das Betätigungselement über eine Stützvorrichtung an einem Trägerelement befestigt ist. Das Trägerelement kann beispielsweise als eine Platte ausgestaltet sein. Die Stützvorrichtung kann beispielsweise auf der Grundlage zumindest einer Blattfeder oder zumindest einer Schenkelfeder oder zumindest eines Stabes ausgestaltet sein. Das Trägerelement ist dabei zusammen mit dem Betätigungselement in dem Gehäuse bewegbar gelagert. Mit anderen Worten wird bei Bewegen des Betätigungselements auch das Trägerelement bewegt. Das zumindest eine Zentrierelement ist nun in der Ruhelage nicht direkt an dem Betätigungselement angeordnet, sondern zwischen dem Trägerelement und dem Gehäuse. Mit anderen Worten wird das Betätigungselement indirekt über das Trägerelement mittels des zumindest einen Zentrierelements in der Ruhelage fixiert. Hierdurch ergibt sich der Vorteil, dass ein tieferer Spalt oder eine tiefere Fuge um das Betätigungselement herum bereitgestellt werden kann. Insbesondere ist das zumindest eine Zentrierelement mehr als 1 Zentimeter, insbesondere mehr als 2 Zentimeter tief in dem Spalt oder der Fuge innerhalb des Gehäuses angeordnet. Die Zentrierung über das Trägerelement hat mit anderen Worten den Vorteil, dass das zumindest eine Zentrierelement nicht an der Oberfläche sichtbar wird. In der Ruhelage ist das Trägerelement durch das Zentrierelement gefangen. Durch eine Stützvorrichtung, die zumindest eine Blattfeder oder zumindest eine Schenkelfeder aufweist, ist zudem eine Relativbewegung des Betätigungselements zum Trägerelement möglich, so dass das Betätigungselement die Feedback-Bewegung auch unabhängig vom Trägerelement ausführen kann. Dennoch ist über eine Blattfeder und eine Schenkelfeder jeweils auch eine Bedienkraft vom Betätigungselement hin zum Trägerelement übertragbar. Der Haltegriff oder die Fixierung von Zentrierelement zu Trägerelement ist auf die Ruhelage begrenzt. Bei der Betätigung des Betätigungselement entsteht ein Freigang in der Freilage, um die Reibung so gering wie möglich zu halten.

Gemäß einer Weiterbildung ist das Betätigungselement nicht als einzelne Taste, sondern als Touchpad oder als Tastenleiste ausgestaltet. Die Sensoreinrichtung ist hierbei derart eingerichtet, dass sie durch das Sensorsignal eine Berührstelle, an welcher der Benutzer die Bedienoberfläche berührt, signalisiert. Mit anderen Worten wird durch das Berührsignal zwischen zumindest zwei unterschiedlichen Berührstellen unterschieden, insbesondere mehr als zwei. Im Zusammenhang mit einem Touchpad kann beispielsweise eine Koordinate der Berührstelle auf der Bedienoberfläche angegeben sein. Im Zusammenhang mit einer Tastenleiste kann durch das Sensorsignal angegeben sein, welche derjenigen Tasten berührt wurde, durch welche die Tastenleiste gebildet ist. Durch die Weiterbildung ergibt sich der Vorteil, dass mittels der Aktoreinrichtung die haptische Rückmeldung in Form einer Feedback-Bewegung für das gesamte Touchpad oder alle Tasten der Tastenleiste bereitgestellt wird und hierzu aber nur eine einzige Aktoreinrichtung nötig ist. Beispielsweise kann die Aktoreinrichtung einen Elektromotor oder einen Elektromagneten oder ein Piezoelement aufweisen, mittels welchem jeweils das Betätigungselement in die Feedback-Bewegung versetzt und hierdurch für das gesamte Betätigungselement das haptische Feedback erzeugt wird.

Gemäß einer Weiterbildung ist ein Kraftsensor bereitgestellt, welcher ein Kraftsignal erzeugt, das mit einer Bedienkraft, mit welcher das Betätigungselement beaufschlagt ist, korreliert ist. Die Steuereinrichtung ist dabei derart eingerichtet, dass sie das Steuersignal für das zumindest eine Gerät des Kraftfahrzeugs nur erzeugt, falls das Kraftsignal eine Bedienkraft größer als ein vorbestimmter Schwellenwert signalisiert. Mit anderen Worten muss der Benutzer nicht nur das Betätigungselement an der Bedienoberfläche berühren, sondern zudem eine Mindestkraft als Bedienkraft auf die Bedienoberfläche ausüben. Hierdurch ergibt sich der Vorteil, dass eine ungewollte oder versehentliche Erzeugung eines Steuersignals aufgrund einer zufälligen oder versehentlichen Berührung des Betätigungselements vermieden ist. Der Benutzer muss willentlich die Bedienkraft aufbringen, die größer als der Schwellenwert ist, um eine Erzeugung des Steuersignals zu bewirken.

Gemäß einer Weiterbildung weist das zumindest eine Zentrierelement ein elastisches Material auf. Bei dem Material kann es sich beispielsweise um einen Schaum, Silikon oder Filz handeln. Hierdurch ergibt sich der Vorteil, dass die Bedieneinrichtung in der Ruhelage des Betätigungselements abgedichtet werden kann, indem das zumindest eine Zentrierelement das Betätigungselement vollumfänglich umfasst oder abschließt oder einfasst. Das zumindest eine Zentrierelement kann auch aus einem starren Material gebildet sein. Insbesondere kann das zumindest eine Zentrierelement einstückig mit dem Gehäuse ausgebildet sein, beispielsweise als ein Fortsatz einer Gehäusewandung des Gehäuses.

Gemäß einer Weiterbildung weist das zumindest eine Zentrierelement jeweils eine bezüglich der besagten Ausweichbewegung schräg angeordnete Gleitfläche für das Betätigungselement auf. Mit anderen Worten ist durch das zumindest eine Zentrierelement ein Trichter oder ein Führung gebildet. Falls das Betätigungselement in die Freistellung ausgelenkt ist und danach zurück in die Ruhelage kehrt, wird es durch die Gleitflächen in die Ruhelage geführt. Hierdurch ist eine zuverlässige Rückstellung des Betätigungselements in die Ruhelage gewährleistet. Mit anderen Worten ist eine Verkantung des Betätigungselements an dem zumindest einen Zentrierelement vermieden.

Wie bereits ausgeführt, gehört zu der Erfindung auch ein Kraftfahrzeug. Das Kraftfahrzeug weist zumindest ein Gerät auf, bei dem es sich um jeweils eines der bereits genannten Geräte handeln kann. Des Weiteren ist bei dem erfindungsgemäßen Kraftfahrzeug eine Ausführungsform der erfindungsgemäßen Bedienvorrichtung bereitgestellt, die mit dem zumindest einen Gerät gekoppelt ist und dazu ausgelegt ist, ihr Steuersignal an das zumindest eine Gerät auszusenden.

Das erfindungsgemäße Kraftfahrzeug ist bevorzugt als Kraftwagen, insbesondere als Personenkraftwagen, ausgestaltet.

Im Folgenden ist ein Ausführungsbeispiel der Erfindung beschrieben. Hierzu zeigt:
- Fig. 1: eine schematische Darstellung einer Ausführungsform des erfindungsgemäßen Kraftfahrzeugs mit einer Bedienvorrichtung, bei welcher ein Betätigungselement in der Ruhelage angeordnet ist,
- Fig. 2: das Kraftfahrzeug von Fig. 1, wobei das Betätigungselement in einer Freilage angeordnet ist,
- Fig. 3: eine schematische Darstellung einer weiteren Ausführungsform des erfindungsgemäßen Kraftfahrzeugs mit einer Bedienvorrichtung, deren Betätigungselement in der Ruhelage angeordnet ist,
- Fig. 4: das Kraftfahrzeug von Fig. 3, wobei das Betätigungselement in der Freilage angeordnet ist,
- Fig. 5: eine schematische Darstellung einer Bedienvorrichtung mit einer Blende und einer durch die Blende und ein Betätigungselement gebildeten Mulde.

Bei dem im Folgenden erläuterten Ausführungsbeispiel handelt es sich um eine bevorzugte Ausführungsform der Erfindung. Bei dem Ausführungsbeispiel stellen die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

In den Figuren sind funktionsgleiche Elemente jeweils mit denselben Bezugszeichen versehen.

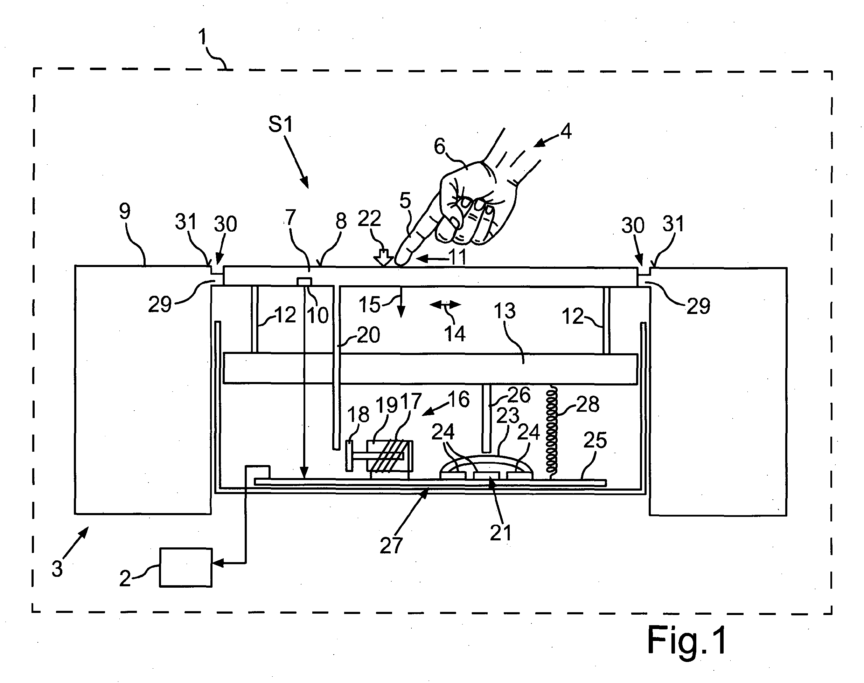

Fig. 1 zeigt ein Kraftfahrzeug 1, bei dem es sich beispielsweise um einen Kraftwagen, insbesondere einen Personenkraftwagen, handeln kann. Dargestellt sind ein Gerät 2 und eine Bedienvorrichtung 3 für das Gerät 2. Bei dem Gerät 2 kann es sich beispielsweise um ein Infotainmentsystem oder eine Klimaanlage oder eine Telefonanlage oder eine Fahrwerkssteuerung handeln. Die Bedienvorrichtung 3 kann auch mit mehreren Geräten gekoppelt sein. Zum Bedienen des Geräts 2 mittels der Bedienvorrichtung 3 kann ein Benutzer 4 mit einem Finger 5 einer Hand 6 ein Betätigungselement 7 an einer Bedienoberfläche 8 berühren und das Betätigungselement 7 aus einer in Fig. 1 dargestellten Ruhelage S1 in ein Gehäuse 9 der Bedienvorrichtung 3 hineindrücken.

Eine Sensoreinrichtung 10 kann hierbei einen Berührort oder eine Berührstelle 11 des Fingers 5 an der Bedienoberfläche 8 erfassen.

Das Betätigungselement 7 kann beispielsweise als Touchpad ausgestaltet sein, wobei eine Sensormatrix des Touchpads die Sensoreinrichtung 10 darstellt. Das Betätigungselement 7 kann auch als Taste oder Tastenleiste ausgestaltet sein, wobei dann die Sensoreinrichtung 10 unterscheidet, welche Taste der Tastenleiste durch den Finger 5 berührt worden ist.

Das Betätigungselement 7 kann über eine Stützvorrichtung 12 an einem Trägerelement 13 befestigt sein. Die Stützvorrichtung 12 kann beispielsweise eine oder mehrere Blattfedern aufweisen, welche eine Bewegung des Betätigungselements 8 bezüglich des Trägerelements 13 in eine Querrichtung 14 quer oder senkrecht zu einer betätigungsbedingten Auslenkrichtung 15 des Betätigungselements 8 ermöglicht. Die Auslenkrichtung 15 ist diejenige Richtung, in welche der Benutzer mit dem Finger 5 das Betätigungselement 8 bei einer Bedienung in das Gehäuse 9 hineinschiebt oder hineindrückt. Das Trägerelement 13 kann beispielsweise eine Platte sein, die zur Gewichtsreduzierung auch eine wabenförmige Struktur aufweisen kann.

Zum Erzeugen einer haptischen Feedback-Bewegung entlang der Querrichtung 14 ist eine Aktoreinrichtung 16 bereitgestellt, die beispielsweise auf der Grundlage einer elektrischen Spule 17 gebildet sein kann, die auf einen thermomagnetischen oder weichmagnetischen Stempel 18 eine Wechselkraft in Abhängigkeit von einem Spulenstrom erzeugen kann. Zur Verstärkung der Wechselkraft kann ein weichmagnetischer Eisenkern 19 vorgesehen sein. Die Wechselkraft des Stempels 18 kann über ein Hebelelement 20 auf das Betätigungselement 7 übertragen werden, so dass die Bedienoberfläche 8 vibriert oder zittert oder eine Stoßbewegung ausführt.

Zusätzlich zu der Sensoreinrichtung 10 kann ein Kraftsensor 21 bereitgestellt sein, welcher eine von dem Finger 5 auf die Bedienoberfläche 8 ausgeübte Bedienkraft 22 erfasst. Der Kraftsensor 21 kann beispielsweise auf der Grundlage einer Tellerfeder 23 und elektrischen Leiterbahnen 24 einer Leiterplatte 25 gebildet sein. Eine Kraftübertragung von beispielsweise dem Trägerelement 13 zu der Tellerfeder 23 kann durch ein Stabelement 26 vorgesehen sein.

Eine elektronische Schaltung der Leiterplatte 25 stellt eine Steuereinrichtung 27 bereit, die mit der Sensoreinrichtung 10, der Aktoreinrichtung 16, dem Kraftsensor 21 und dem Gerät 2 gekoppelt ist.

Das Betätigungselement 7 und mit ihm das Trägerelement 13 werden durch eine Rückstelleinrichtung 28 in der in Fig. 1 dargestellten Ruhelage S1 gehalten. Die Rückstelleinrichtung 28 kann beispielsweise eine Spiralfeder oder Blattfeder aufweisen.

In der Ruhelage S1 ist das Betätigungselement 7 derart festgelegt, dass es eine Bewegung in die Querrichtung 14 nicht ausführen kann, das heißt die Bewegung in die Querrichtung 14 ist blockiert. Hierzu ist das Betätigungselement 7 durch ein Zentrierelement 29 bezüglich der Querrichtung 14 fixiert. Das Zentrierelement 29 kann beispielsweise durch einen das Betätigungselement 7 umgebenden Steg oder Rippe oder Vorsprung gebildet sein. Das Zentrierelement 29 kann beispielsweise an dem Gehäuse 9 beispielsweise mittels eines Spritzgussverfahrens ausgeformt sein. Das Zentrierelement 29 kann alternativ an dem Betätigungselement 7 befestigt sein. Zwischen dem Betätigungselement 7 und dem Gehäuse 9 ist eine Fuge 30 ausgebildet, in welcher das Zentrierelement 29 angeordnet sein kann. Die Bedienoberfläche 8 kann bündig mit einer Außenseite oder einer Blende 31 des Gehäuses 8 abschließen oder angeordnet sein.

Durch das Zentrierelement 29 ist das Erzeugen der beschriebenen haptischen Feedback-Bewegung an der Oberfläche 8 blockiert oder verhindert. Dafür sitzt das Betätigungselement 7 derart fest in der Ruhelage S1, dass sich eine Spaltbreite der Fuge 30 während beispielsweise einer Fahrt des Kraftfahrzeugs 1 auch aufgrund von Vibrationen nicht ändert. Insbesondere ist eine Toleranz oder ein Unterschied des Spaltmaßes entlang der gesamten Fuge 30 kleiner als 0,5 Millimeter.

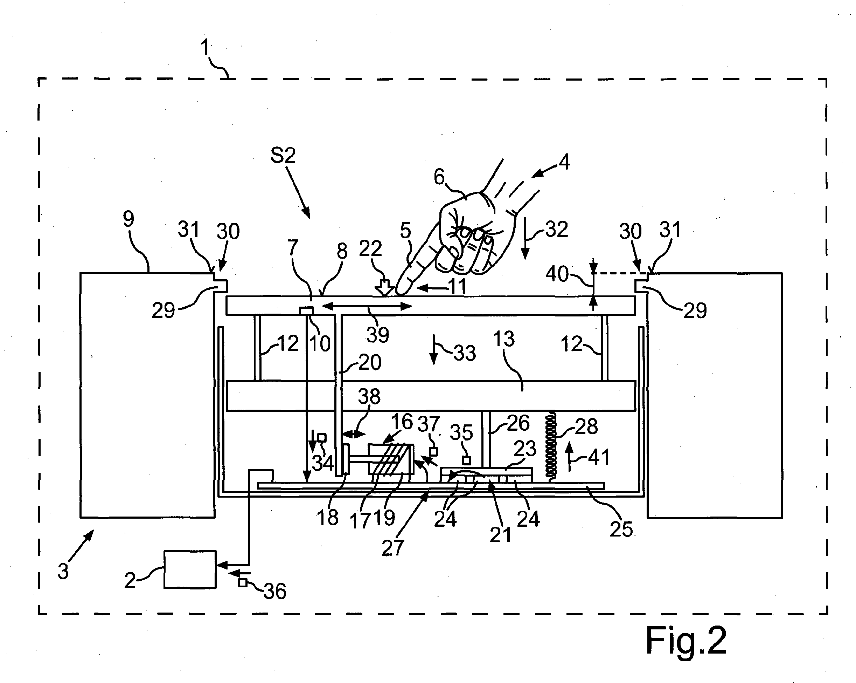

In Fig. 2 ist ein Betätigungsvorgang oder Bedienvorgang der Bedienvorrichtung 3 durch den Benutzer 4 veranschaulicht.

In Fig. 2 ist dargestellt, wie der Benutzer 4 mit dem Finger 5 die Bedienkraft 22 auf die Bedienoberfläche 8 ausübt und hierbei eine Bedienbewegung 32 ausführt, so dass das Betätigungselement 7 eine Ausweichbewegung 33 der Bedienkraft 22 folgend ausführt. Die Sensoreinrichtung 10 signalisiert durch ein Sensorsignal 34 die Berührung der Bedienoberfläche 8. Falls die Bedienkraft 22 groß genug ist, ist eine Ausweichstrecke oder ein Bewegungsweg 35 des Betätigungselements 7 derart groß, dass der Kraftsensor 21 ein Kraftsignal 35 erzeugt, durch welches signalisiert ist, dass die Bedienkraft 22 größer als ein vorgegebener Schwellenwert ist. Beispielsweise kann durch die Tellerfeder ein Kurzschluss zwischen den Leiterbahnen 24 verursacht werden, falls die Bedienkraft 22 den Schwellenwert übersteigt.

In Abhängigkeit von dem Sensorsignal 34 und dem Kraftsignal 35 erzeugt die Steuereinrichtung 27 ein Steuersignal 36, das an das Gerät 2 ausgesendet wird. In dem Gerät 2 wird hierdurch eine Funktion des Geräts 2 aktiviert. Des Weiteren erzeugt die Steuereinrichtung 27 ein Aktivierungssignal 37, durch welches die Aktoreinrichtung 16 aktiviert wird. Beispielsweise kann das Aktivierungssignal 37 durch einen Wechselstrom oder durch einen Stromimpuls gebildet sein. Die elektrische Spule 17 erzeugt dann eine entsprechende Vibrationsbewegung oder Impulsbewegung 38 des Stempels 18. Die Bewegung wird über das Hebelelement 20 auf das Betätigungselement 7 übertragen, welches hierdurch die Feedback-Bewegung 39 entlang der Querrichtung 14 ausführt. Eine Bewegungsebene oder Bewegungsrichtung der Feedback-Bewegung 39 steht schräg oder senkrecht zur Bewegungsrichtung der Ausweichbewegung 33. Insbesondere ist die Bewegungsrichtung der Feedback-Bewegung 39 ist insbesondere koplanar zur Bedienoberfläche 8 ausgerichtet.

Damit das Betätigungselement 7 sich frei bewegen kann, das heißt die Feedback-Bewegung 39 überhaupt ausführen kann, ist ein Bewegungsweg oder Auslenkweg 40 derart groß, dass das Zentrierelement 29 das Betätigungselement 7 für die Feedback-Bewegung 39 freigegeben hat. Mit anderen Worten ist der Auslenkweg 40 derart groß, dass sich das Betätigungselement 7 von der Ruhelage S1 in eine Freilage S2 bewegt oder dorthin gewechselt hat. In der Freilage S2 sind das Zentrierelement 29 und das Betätigungselement 7 berührungsfrei zueinander angeordnet. In der Ruhelage S1 berührt dagegen das Zentrierelement 29 das Betätigungselement 7 und hält es hierdurch in der Ruhelage S1 in Bezug auf die Richtung der Feedback-Bewegung 39 fest.

Sobald der Benutzer den Finger 5 von dem Betätigungselement 7 löst, wird das Betätigungselement 7 zusammen mit dem Trägerelement 13 durch eine Rückstellkraft 41 der Rückstelleinrichtung 28 aus der Freilage S2 in die Ruhelage S1 zurückbewegt.

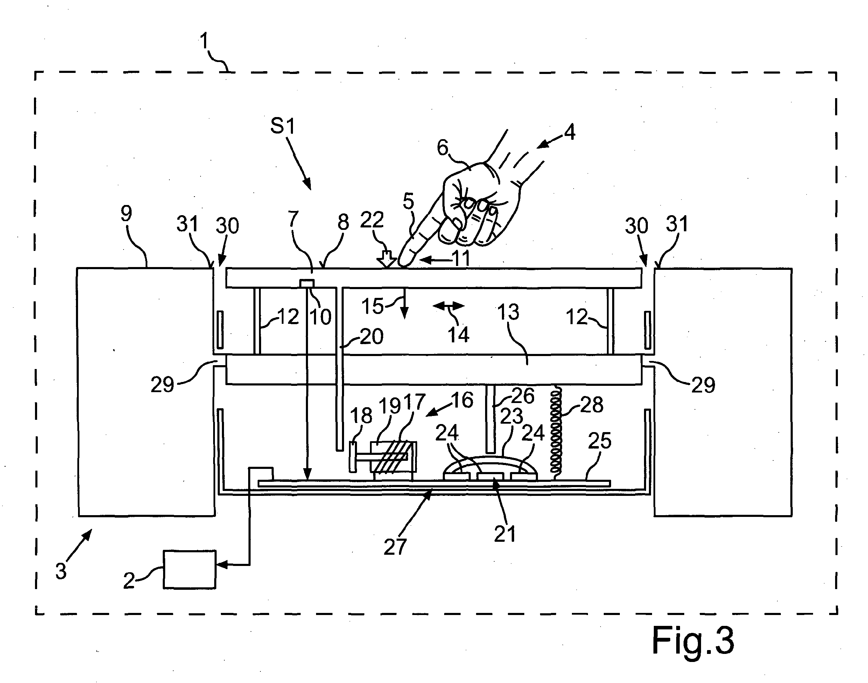

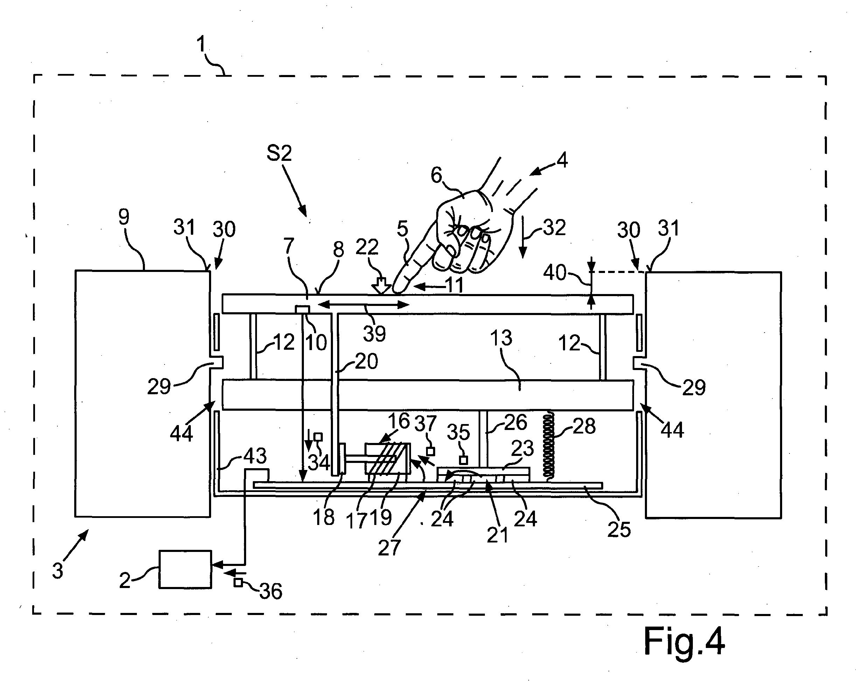

In Fig. 3 und Fig. 4 ist eine alternative Ausgestaltung der Bedienvorrichtung 3 in Bezug auf die Anordnung des Zentrierelements 29 veranschaulicht. Die übrigen Elemente der Bedienvorrichtung 3 können in derselben Weise wie in Fig. 1 und Fig. 2 veranschaulicht ausgestaltet sein. Aus diesem Grund beschränkt sich die folgende Darstellung der Bedienvorrichtung 3 gemäß der Fig. 3 und der Fig. 4 auf die alternative Anordnung des Zentrierelements 29.

In Fig. 3 ist das Betätigungselement 7 in einer Ruhelage S1 dargestellt, in welcher das Betätigungselement 7 aber nicht direkt durch ein Zentrierelement, sondern indirekt über das Trägerelement 7 und die Stützvorrichtung 12 gehalten wird. Die Stützvorrichtung 12 kann hierbei beispielsweise durch mindestens einen starren Stab bereitgestellt sein, welcher das Betätigungselement 7 und das Trägerelement 13 gegenseitig fixiert. Stützvorrichtung 12 kann aber auch durch z.B. eine Blattfeder aufweisen.

In der Ruhelage S1 ist das Trägerelement 13 durch ein Zentrierelement 29 in eine Querrichtung 14 senkrecht zur Betätigungsrichtung oder Auslenkrichtung 15 fixiert. Hierdurch kann ein tieferer Spalt oder eine tiefere Fuge 30 bereitgestellt werden.

Wie in Fig. 4 dargestellt, kann des Weitern ein Auslenkweg 40 der Bedienoberfläche 8 bei der Betätigungsbewegung 32 kleiner ausgestaltet sein als bei der in Fig. 1 und Fig. 2 veranschaulichten Ausführungsformen. Grund dafür ist, dass das Zentrierelement 29 an einer Kante des Trägerelement 13 angeordnet sein kann, die zur Fuge 30 hin ausgerichtet ist.

Fig. 4 veranschaulicht des Weiteren, wie der Benutzer mit dem Finger 5 durch Ausüben der Bedienkraft 22 an der Bedienoberfläche 8 das Sensorsignal 34 und das Kraftsignal 35 erzeugt und hierdurch durch die Steuereinrichtung 27 das Steuersignal 36 und mit dem Steuersignal 36 das Aktivierungssignal 37 erzeugt wird. Hierdurch wird mittels der Aktoreinrichtung 16 das Betätigungselement 7 bewegt, so dass es die Feedback-Bewegung 39 ausführt. In der in Fig. 4 dargestellten Freilage S2 berührt das Zentrierelement 29 weder das Betätigungselement 7 noch das Trägerelement 13. Dagegen wird in der Ruhelage S1 das Trägerelement 13 von dem Zentrierelement 29 berührt.

Um eine Bewegung des Trägerelements 13 in der Freilage S2 zu ermöglichen, kann eine Gehäuseschale 42 des Gehäuses 9 eine Aussparung 44 aufweisen, in welche das Trägerelement 13 beim Ausführen der Feedback-Bewegung 39 eintauchen kann.

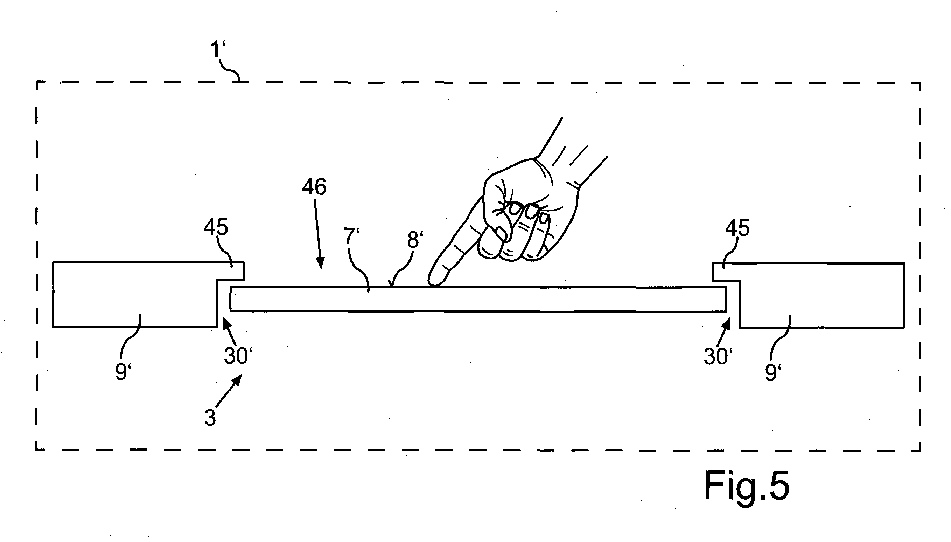

Fig. 5 zeigt noch einmal zur Veranschaulichung einen Kraftwagen 1, welcher in einer aus dem Stand der Technik bekannten Weise ein Betätigungselement 7' mit einer Bedienoberfläche 8' aufweist. Das Betätigungselement 7' ist bei der in Fig. 5 gezeigten Bedieneinrichtung 3' nicht durch ein Zentrierelement fixiert. Eine Fuge 30' zwischen dem Betätigungselement 7' und Gehäuse 9' ist durch eine die Fuge 3' überragende oder abdeckende Blende oder Schindelung 45 für den Blick eines Benutzers abgedeckt, damit der Benutzer einen unregelmäßigen Verlauf einer Spaltbreite der Fuge 30' nicht erkennen kann.

Des Weiteren entsteht durch die Blende 45 eine Mulde 46, in welcher die Bedienoberfläche 8' versenkt angeordnet ist.

Bei dem erfindungsgemäßen Kraftfahrzeug in der in Fig. 1 bis Fig. 4 gezeigten Weise dagegen das Betätigungselement 7 mittels des Zentrierelements 29 zentriert ist, kann auf die Spaltabdeckung der Fuge 30 durch eine Blende 45 verzichtet werden und durch bündiges Anordnen der Bedienoberfläche 8 mit der Blende 31 des Gehäuses 9 die Mulde 46 vermieden werden.

Hierzu wird in der beschriebenen Weise an der Gehäusekante oder den Blendenrand der Blende, welche das Betätigungselement 7 umschließt, eine Zentrierrippe als Zentrierelement angebracht. Die Oberfläche 8 oder das Trägerelement 13 werden durch diese Zentrierrippe in ihre Ausgangslage oder Ruhelage S1 gedrückt/dort fixiert. Dadurch ergibt sich ein gleichmäßiger umlaufender Spalt, das heißt das Fugenmaß der Fuge 30 kann in einem vorgegebenen Toleranzbereich gehalten werden. Hierbei hat eine direkte Zentrierung des Betätigungselements 7, wie es in Fig. 1 und Fig. 2 dargestellt ist, zur umlaufenden Blende toleranztechnische Vorteile, da die kleinstmögliche Toleranzkette ermöglicht ist. Beim Betätigen des Betätigungselements 7 wird das Betätigungselement 7 und gegebenenfalls das Trägerelement 13 ausgelenkt und dadurch von dem Zentrierelement 29 weg bewegt. Das heißt durch den Betätigungshub mit dem Auslenkweg 40 wird das Betätigungselement 7 beziehungsweise der Träger 13 freigegeben. Dies ist nötig, denn durch die Aktoreinrichtung 16 wird dann das Betätigungselement 7 in Schwingung versetzt, so dass es die Feedback-Bewegung 39 ausführt. Dadurch wird ein haptisches Feedback für den Benutzer 4 an der Bedienoberfläche 8 erzeugt.

Insgesamt zeigt das Beispiel, wie durch die Erfindung eine Zentrierung eines von einer Aktoreinrichtung angeregten Bedienteils erreicht werden kann.

## Patentansprüche

1. Bedienvorrichtung (3) für ein Kraftfahrzeug (1), aufweisend:
- ein Betätigungselement (7), das bezüglich eines Gehäuses (9) der Bedienvorrichtung (3) bewegbar gelagert ist und das eine Berühroberfläche (8) für einen Benutzer (4) aufweist,
- eine Sensoreinrichtung (10) zum Erzeugen eines Sensorsignals (34) in Abhängigkeit von einer benutzerseitigen Berührung der Berühroberfläche (8) und/oder Annäherung an die Berühroberfläche (8),
- eine Aktoreinrichtung (16) zum Erzeugen einer Feedback-Bewegung (39) des Betätigungselements (7) in Abhängigkeit von einem Anregungssignal (37),
- eine Steuereinrichtung (27), die derart eingerichtet ist, dass sie in Abhängigkeit von dem Sensorsignal (34) ein Steuersignal (36) für zumindest ein Gerät (2) des Kraftfahrzeugs (1) und mit dem Steuersignal (36) das Anregungssignal (37) für die Aktoreinrichtung (16) erzeugt, wobei das Betätigungselement (7) im unbetätigtem Zustand in einer Ruhelage (S1) angeordnet ist, in welcher zumindest ein Zentrierelement (29) die Feedback-Bewegung (39) blockiert, und bei einer benutzerseitigen Beaufschlagung der Berühroberfläche (8) mit einer Bedienkraft (22) eine schräg oder senkrecht zur Richtung (14) der Feedback-Bewegung (39) ausgerichtete Ausweichbewegung (33) ausführt, durch welche das Betätigungselement (7) von der Ruhelage (S1) in eine Freilage (S2), in welcher es durch das zumindest eine Zentrierelement (29) für die Feedback-Bewegung (39) freigegeben ist, wechselt.

2. Bedienvorrichtung (3) nach Anspruch 1, wobei eine elastisch verformbar ausgestaltete Rückstelleinrichtung (28) das Betätigungselement (7) mit einer Rückstellkraft (41) zur Ruhelage (S1) hin drückt oder zieht.

3. Bedienvorrichtung (3) nach einem der vorhergehenden Ansprüche, wobei das zumindest eine Zentrierelement (29) in der Ruhelage (S1) des Betätigungselements (7) zwischen dem Betätigungselement (7) und einer das Betätigungselement (7) umschließenden Blende (31) des Gehäuses (9) angeordnet ist.

4. Bedienvorrichtung (3) nach Anspruch 3, wobei zwischen dem Betätigungselement (7) und dem Gehäuse (9) eine Fuge (30) ausgebildet ist und das zumindest eine Zentrierelement (29) in einem Abstand größer als Null zur Berühroberfläche (8) in der Fuge (30) angeordnet ist.

5. Bedienvorrichtung (3) nach einem der Ansprüche 1 oder 2, wobei das Betätigungselement (7) über eine Stützvorrichtung (12) an einem Trägerelement (13) befestig ist und das Trägerelement (13) zusammen mit dem Betätigungselement (7) in dem Gehäuse (9) bewegbar gelagert ist und das zumindest eine Zentrierelement (29) in der Ruhelage (S1) zwischen dem Trägerelement (13) und dem Gehäuse (9) angeordnet ist.

6. Bedienvorrichtung (3) nach einem der vorhergehenden Ansprüche, wobei das Betätigungselement (7) als Touchpad oder als Tastenleiste ausgestaltet ist und Sensoreinrichtung (10) derart eingerichtet ist, dass sie durch das Sensorsignal (34) eine Berührstelle (11), an welcher der Benutzer (4) die Bedienoberfläche (8) berührt, signalisiert.

7. Bedienvorrichtung (3) nach einem der vorhergehenden Ansprüche, wobei ein Kraftsensor (21) bereitgestellt ist, welcher ein Kraftsignal (35) erzeugt, das mit der Bedienkraft (22) korreliert ist, und wobei die Steuereinrichtung (27) derart eingerichtet ist, dass sie das Steuersignal (10) nur erzeugt, falls das Kraftsignal (35) eine Bedienkraft (22) größer als ein vorbestimmter Schwellenwert signalisiert.

8. Bedienvorrichtung (3) nach einem der vorhergehenden Ansprüche, wobei das zumindest eine Zentrierelement (29) ein elastisches Material aufweist.

9. Bedienvorrichtung (3) nach einem der vorhergehenden Ansprüche, wobei das zumindest eine Zentrierelement (29) jeweils eine bezüglich der Ausweichbewegung (33) schräg angeordnete Gleitfläche für das Betätigungselement (7) aufweist.

10. Kraftfahrzeug (1) mit zumindest einem Gerät (2) und mit einer Bedienvorrichtung (3) nach einem der vorhergehenden Ansprüche, wobei die Bedienvorrichtung (3) mit dem zumindest einen Gerät (2) gekoppelt ist und dazu ausgelegt ist, ihr Steuersignal (36) an das zumindest eine Gerät (2) auszusenden.

## Claims

1. Operating device (3) for a motor vehicle (1), having:
- an operating element (7), which is mounted movably relative to a housing (9) of the operating device (3) and has a contact surface (8) for a user (4),
- a sensor device (10) for generating a sensor signal (34) as a function of a user contact of the contact surface (8) and/or approach to the contact surface (8),
- an actuator (16) for generating a feedback movement (39) of the operating element (7) as a function of an excitation signal (37),
- a controller (27), which is configured as a function of the sensor signal (34) to produce a control signal (36) for at least one device (2) of the motor vehicle (1) and with the control signal (36) generates the excitation signal (37) for the actuator (16),
wherein the operating element (7) in the inactivated state is arranged in a position of rest (S1), in which at least one centring element (29) blocks the feedback movement (39), and with the user activation of the contact surface (8) with operational force (22) performs an evasive movement (33) which is oblique or perpendicular to the direction (14) of the feedback movement (39), by means of which evasive movement the operating element (7) changes from the position of rest (S1) into a free position (S2), in which it is released by the at least one centring element (29) for the feedback movement (39).

2. Operating device (3) according to claim 1, wherein an elastically deformable restoring device (28) pushes or pulls the operating element (7) with a restoring force (41) to the position of rest (S1).

3. Operating device (3) according to any of the preceding claims, wherein the at least one centring element (29) is arranged in the position of rest (S1) of the operating element (7) between the operating element (7) and a screen (31) of the housing (9) surrounding the operating element (7).

4. Operating device (3) according to claim 3, wherein a joint (30) is formed between the operating element (7) and the housing (9) and the at least one centring element (29) is arranged in the joint (30) at a distance greater than zero from the contact surface (8).

5. Operating device (3) according to any of claims 1 or 2, wherein the operating element (7) is secured by a support device (12) onto a support element (13) and the support element (13) together with the operating element (7) is mounted movably in the housing (9) and the at least one centring element (29) is arranged in the position of rest (S1) between the support element (13) and the housing (9).

6. Operating device (3) according to any of the preceding claims, wherein the operating element (7) is designed as a touchpad or as a button bar and the sensor device (10) is configured such that it signals via the sensor signal (34) a touch point (11) where the user (4) touches the operating surface (8).

7. Operating device (3) according to any of the preceding claims, wherein a force sensor (21) is provided which generates a force signal (35) which is correlated with the operational force (22), and wherein the control device (27) is configured such that it only generates the control signal (10) if the force signal (35) signals an operational force (22) that is greater than a prespecified threshold value.

8. Operating device (3) according to any of the preceding claims, wherein the at least one centring element (29) includes an elastic material.

9. Operating device (3) according to any of the preceding claims, wherein the at least one centring element (29) has a sliding surface for the operating element (7) which is arranged to be oblique relative to the evasive movement (33).

10. Motor vehicle (1) with at least one device (2) and with an operating device (3) according to any of the preceding claims, wherein the operating device (3) is coupled to the at least one device (2) and is configured to send its control signal (36) to the at least one device (2).

## Revendications

1. Dispositif de desserte (3) pour un véhicule automobile (1), présentant :
- un élément d'actionnement (7) qui est monté de manière à pouvoir se déplacer par rapport à un boîtier (9) du dispositif de desserte (3) et présente une surface de contact (8) pour un utilisateur (4),
- un dispositif capteur (10) pour produire un signal de capteur (34) en fonction d'un contact côté utilisateur de la surface de contact (8) et/ou d'un rapprochement de la surface de contact (8),
- un dispositif d'actionnement (16) pour produire un déplacement de rétroaction (39) de l'élément d'actionnement (7) en fonction d'un signal d'excitation (37),
- un dispositif de commande (27) qui est agencé de sorte qu'il produise en fonction du signal de capteur (34) un signal de commande (36) pour au moins un dispositif (2) du véhicule automobile (1) et avec le signal de commande (36) le signal d'excitation (37) pour le dispositif d'actionnement (16),
dans lequel l'élément d'actionnement (7) est agencé à l'état non actionné en position de repos (S1), dans laquelle au moins un élément de centrage (29) bloque le déplacement de rétroaction (39) et effectue, lors d'une sollicitation côté utilisateur d'une force de desserte (22) à la surface de contact (8), un déplacement de dégagement (33) orienté en oblique ou perpendiculairement à la direction (14) du déplacement de rétroaction (39), par lequel déplacement l'élément d'actionnement (7) passe de la position de repos (S1) dans une position libre (S2), dans laquelle il est libéré par l'au moins un élément de centrage (29) pour le déplacement de rétroaction (39).

2. Dispositif de desserte (3) selon la revendication 1, dans lequel un dispositif de rappel (28) agencé de manière à pouvoir se déformer de manière élastique presse ou tire l'élément d'actionnement (7) vers la position de repos (S1) avec une force de rappel (41).

3. Dispositif de desserte (3) selon l'une quelconque des revendications précédentes, dans lequel l'au moins un élément de centrage (29) est agencé en position de repos (S1) de l'élément d'actionnement (7) entre l'élément d'actionnement (7) et un écran (31) du boîtier (9) entourant l'élément d'actionnement (7).

4. Dispositif de desserte (3) selon la revendication 3, dans lequel un joint (30) est formé entre l'élément d'actionnement (7) et le boîtier (9) et l'au moins un élément de centrage (29) est agencé dans le joint (30) à une distance plus grande que zéro de la surface de contact (8).

5. Dispositif de desserte (3) selon l'une quelconque des revendications 1 ou 2, dans lequel l'élément d'actionnement (7) est fixé à un élément de support (13) via un dispositif d'appui (12) et l'élément de support (13) est monté conjointement avec l'élément d'actionnement (7) de manière mobile dans le boîtier (9) et l'au moins un élément de centrage (29) est agencé en position de repos (S1) entre l'élément de support (13) et le boîtier (9).

6. Dispositif de desserte (3) selon l'une quelconque des revendications précédentes, dans lequel l'élément d'actionnement (7) se présente sous la forme d'un bloc à effleurement ou d'une barre à touches et le dispositif capteur (10) est agencé de sorte qu'il signalise par le signal de capteur (34) un point de contact (11) où l'utilisateur (4) vient en contact avec la surface de desserte (8).

7. Dispositif de desserte (3) selon l'une quelconque des revendications précédentes, dans lequel il est aménagé un capteur de force (21) qui produit un signal de force (35) qui est corrélé avec la force de desserte (22) et dans lequel le dispositif de commande (27) est agencé de manière à ne produire le signal de commande (10) qu'au cas où le signal de force (35) signalise une force de desserte (22) plus grande qu'une valeur de seuil prédéterminée.

8. Dispositif de desserte (3) selon l'une quelconque des revendications précédentes, dans lequel l'au moins un élément de centrage (29) présente un matériau élastique.

9. Dispositif de desserte (3) selon l'une quelconque des revendications précédentes, dans lequel l'au moins un élément de centrage (29) présente respectivement une surface de glissement agencée en oblique par rapport au déplacement de dégagement (33) pour l'élément d'actionnement (7).

10. Véhicule automobile (1) comprenant au moins un dispositif (2) et un dispositif de desserte (3) selon l'une quelconque des revendications précédentes, dans lequel le dispositif de desserte (3) est couplé à l'au moins un dispositif (2) et est conçu de manière à envoyer son signal de commande (36) à l'au moins un dispositif (2).
